Europäisches Patentamt

European Patent Office

Office européen des brevets

(11) Publication number: **0 407 169 A2**

## EUROPEAN PATENT APPLICATION

(21) Application number: 90307306.2

(22) Date of filing: 04.07.90

(51) Int. Cl.⁵: **H01J 37/32**, H01L 21/311, H01L 21/321, H01L 21/306

(30) Priority: 04.07.89 JP 172524/89

(43) Date of publication of application:
09.01.91 Bulletin 91/02

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Mihara, Satoru
25-10, Utsukushigaoka 5-chome, Midori-ku
Yokohama-shi, Kanagawa 227(JP)
Inventor: Motoyama, Takushi
159, Shimokodanaka, Nakahara-ku
Kawasaki-shi, Kanagawa 211(JP)

(74) Representative: Silverman, Warren et al
HASELTINE LAKE & CO. Hazlitt House 28
Southampton Buildings Chancery Laneane
London WC2A 1AT(GB)

(54) Electron cyclotron resonance (ECR) plasma etching process and ECR plasma etching apparatus.

(57) An electron cyclotron resonance (ECR) plasma etching process using an ECR etching apparatus having a plasma generation chamber, and gas supply entrances provided in each chamber, comprising the steps of: directing microwaves into said plasma generation chamber, applying a magnetic field to said plasma generation chamber, and supplying a first gas which is used for generating a deposit of a protective film to said reaction chamber.

# F I g. 4

# ELECTRON CYCLOTRON RESONANCE (ECR) PLASMA ETCHING PROCESS AND ECR PLASMA ETCHING APPARATUS

The present invention relates to an électron cyclotron resonance (ECR) plasma etching process and an ECR etching apparatus. More particularly, the invention relates to an ECR plasma etching process and an ECR plasma etching apparatus wherein a resist mask, used when aluminium or an alloy of aluminium and copper, etc., having a small etching rate with a novolak resist is etched, is formed with a high resolution.

To form an aluminium layer having a small etching rate with a novolak resist, and particularly, to form an alloy layer of aluminium and copper, a tri-level resist process is usually utilized because when a single layer resist process is used for etching a material with a small etching rate, a thick resist layer must be formed. Hence the resolution when forming a resist mask by exposure and development using a photo-mask becomes poor.

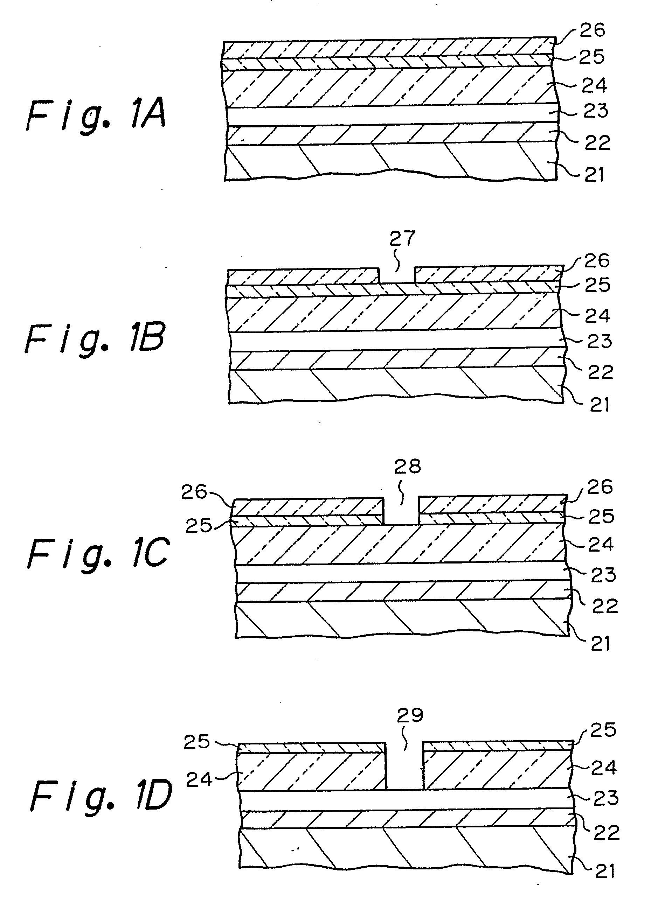

A conventional method for producing a mask for etching, in which. a tri-level resist process is used, will now be explained with reference to Figures 1A to 1D of the accompanying drawings which are cross-sectional step views illustrating an ECR plasma etching process.

As shown in Fig. 1A, a novolak resist OFPR-800 (produced by Tokyo Oka Kogyo) for example, is coated onto an aluminium layer 23, to a thickness of $2\mu m$ to thereby form a lower resist layer 24, which aluminium layer is formed on an insulating layer 22 on a substrate 21. Then a silicon resist, for example OCD-Type 7 (produced by Tokyo Oka Kogyo) is coated on the lower resist layer 24 to a thickness of about 300 mm to form a middle layer 25. Then, the above-mentioned resist OFPR-800 is also coated to a thickness of about 1 $\mu m$ on the middle layer 25, to form an upper resist layer 26. Accordingly, a three-layer resist composed of the above mentioned lower, middle and upper resist layers 24, 25 and 26 is formed on the aluminium layer 23.

Then, as shown in Fig. 1B, exposure and development are carried out by using a photomask, and an opening 27 with a high resolution is formed in the thin upper resist layer 26.

Thereafter, as shown in Fig. 1C, while using the opening 27 formed in the upper resist layer 26 as a mask, the middle layer 25 is etched by a reactive ion etching (RIE) using a mixed gas of $CF_4$ and $CHF_3$, so that an opening 28 is formed in the middle layer 25.

Then, as shown in Fig. 1D, while using the opening 28 formed in the middle layer 25 as a mask, the lower resist layer 24 is etched by a hereinafter-described ECR etching device so that an opening 29 is formed with a high resolution.

In this ECR etching, the upper resist layer 26 is removed, with the result that the shape of the opening 27 formed with a high resolution on the upper resist layer 26 is transferred to thick lower resist layer 24 and an opening 29 is formed. Thereafter, the aluminium layer 23 can be accurately etched by using the opening 29 formed in the thick lower resist layer 24 as a mask.

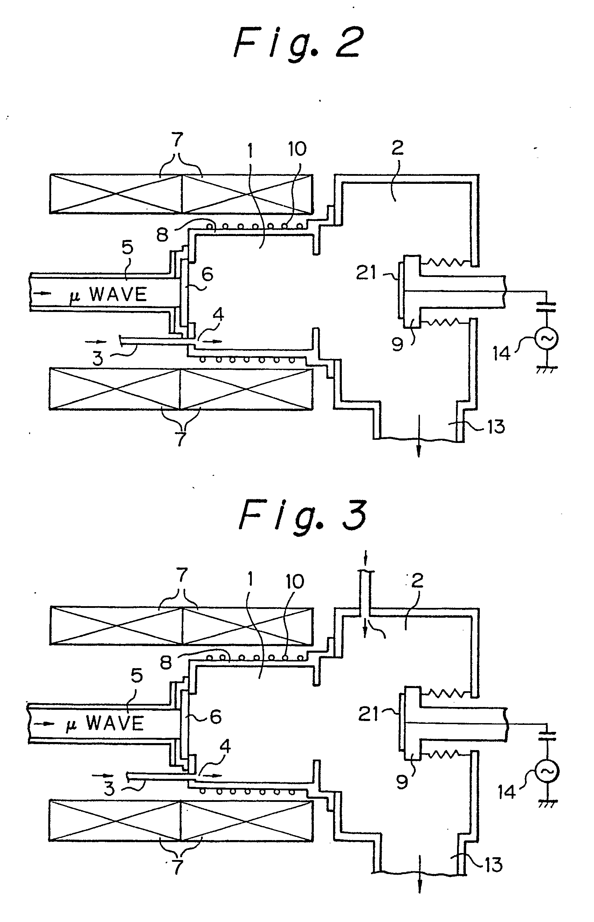

In the drawings, Figure 2 is a schematic view of a conventional ECR etching device.

In Fig. 2, a plasma generation chamber 1 is provided with a gas supply pipe 3 having a gas supply entrance 4, and is connected to and communicates with a reaction chamber 2.

A substrate 21, such as a silicon substrate having a structure shown in Fib. 1C, is provided on a susceptor 9 in the reaction chamber 2. A 200 Khz high frequency power is applied to the substrate 21 from a high frequency power source 14, and a mixed gas of oxygen ($O_2$) and $SiCl_4$ is supplied through the gas supply entrance 4 to the plasma generation chamber 1.

The supplied mixed gas is made into a plasma by the electron cyclotron resonance (ECR) effect due to microwaves introduced through a microwave introducing window 6 and the magnetic field generated by electromagnetic coils 7. The gas plasma is introduced into the reaction chamber 2 with a plasma flow and impinges on the substrate 21, whereby the lower resist layer 24 formed on the substrate 21 is etched. Thereafter, unreacted mixed gas is exhausted through an exhaust vent 13 connected to a pump (not shown).

Formerly only oxygen was supplied to the plasma generation chamber 1 of the ECR etching device for etching, but the ECR etching caused side etching, and thus the accuracy of the shape of the patterns obtained was low. If the accuracy of the shape thereof was to be improved, the etching rate had to be lowered, but this lowered the productivity.

Therefore, to form a highly accurate pattern at a high etching rate, attempts have been made to use an etching process using a mixed gas of $O_2$ supplemented with $BCl_3$, $SiCl_4$ etc. In the thus-improved ECR etching process, the above-mentioned side etching is prevented by depositing a protective film on the side wall, and thus the accuracy of the shape of the etched pattern is enhanced.

Nevertheless, the etching rate of a silicone middle layer 25 and of a novolak lower resist layer 24 when the mixed gas of $O_2$ supplemented with

BCl₃ and SiCl₄, etc., is used, becomes small. Also the middle layer 25 is not satisfactory to be used as a mask when etching the lower resist layer 24, with the result that the accuracy of the shape of the pattern formed in the lower resist layer 24 is low. Further, an oxide formed by reacting $O_2$ with an added gas such as $SiCl_4$, etc., adheres to the microwave introduction window 6, and thus the etching process is destabilized.

Furthermore, since a product of the gases introduced to the plasma generation chamber 1 adheres to the periphery of the surface in which the microwave introduction window 6 is provided, when a gas supply entrance 4 is provided in such a surface, the deposits adhered to the surface are sometimes separated there-from by the force of gas blown thereon, thereby generating contamination in the chamber.

An object of the present invention is to provide an ECR plasma etching process and an ECR plasma etching apparatus wherein a lower resist layer forming a part of a multi-layer resist can be etched in a short time and with a high shape accuracy.

Another object of the present invention is to provide an ECR plasma etching process and an ECR plasma etching apparatus wherein a reaction product does not adhere to a microwave introduction window.

A further object of the present invention is to provide an ECR plasma etching apparatus wherein a reaction product adhered to a plasma generation chamber does not separate therefrom and hence does not generate contamination.

Accordingly, there is provided an electron cyclotron resonance (ECR) plasma etching process using an ECR etching apparatus having a plasma generation chamber, a reaction chamber connected with said plasma generation chamber, and gas supply entrances provided in the respective chambers, comprising the steps of:
directing microwaves into said plasma generation chamber,
applying a magnetic field to said plasma generation chamber,
supplying a first gas which is used for generating plasma, to said plasma generation chamber, and
supplying a second gas which is used for generating a deposit of a protective film to said reaction chamber.

According to the present invention, the first gas, which is used for generating a plasma, is advantageously constituted by one or more of argon (Ar), oxygen ($O_2$), nitrogen ($N_2$), helium (He), xenon (Xe), krypton (Kr), chlorine ($Cl_2$), fluorine ($F_2$), nitrogen trifluoride ($NF_3$), sulphur hexafluoride ($SF_6$), hydrogen chloride (HCl), hydrogen fluoride (HF), bromine ($Br_2$), hydrogen bromide (HBr), nitrogen dioxide ($NO_2$), nitrogen monoxide (NO), carbon dioxide ($CO_2$), and carbon monoxide (CO).

Also, according to the present invention, the material to be etched is preferably aluminium, an aluminium alloy, a resist, a polymer compound, a silicon, an alloy or compound of silicon and a refractory metal, a high refractory metal, a stacked body formed of an alloy or compound of silicon and a refractory metal, or a refractory metal.

Further, according to the present invention the material to be etched is preferably a resist or a high polymer compound, the first gas, which is used for generating the plasma, is preferably oxygen or a mixed gas of oxygen and carbon dioxide, and the second gas, which is used for generating the deposit, is preferably constituted by one or more of carbon dioxide ($CO_2$), chlorine ($Cl_2$), boron trichloride ($BCl_3$), silicon tetrachloride ($SiCl_4$), silicon tetrafluoride ($SiF_4$), silicon tetrabromide ($SiBr_4$), titanium tetrachloride ($TiCl_4$), hydrogen bromide (HBr), bromine ($Br_2$), sulphur dioxide ($SO_2$), disulphur dichloride ($S_2Cl_2$), sulphur dichloride ($SCl_2$), carbon monoxide (CO), hydrogen fluoride (HF), and hydrogen chloride (HCl).

According to the present invention, water is preferably added to the second gas used for generating the deposit.

Further, according to the present invention there is provided an electron cyclotron resonance (ECR) plasma etching apparatus comprising:
a plasma generation chamber having a microwave introduction window and a first supply entrance for a first gas which is a plasma generating gas, and having electromagnetic coils wound therearound, and
a reaction chamber communicating with said plasma generation chamber having a second supply entrance for a second gas which is a gas for generating a deposit to form a side etching prevention film and having a susceptor on which is to be provided a substrate and the main surface of which is positioned to face a plasma flow which flows, when the apparatus is in use, from said plasma generation chamber.

According to the present invention, by supplying only a gas which is used for generating a plasma into the plasma generation chamber, and by supplying only a gas which is used for depositing a side-etching prevention film into the reaction chamber, only a small amount of gas is needed to form the side-etching prevention film. Therefore, a highly accurate pattern can be formed in the lower resist layer. Further, when water is added to the gas introduced in the reaction chamber, the deposition rate is enhanced and the side-etching prevention effect is further enhanced.

Further according to the present invention there is provided an electron cyclotron resonance (ECR) plasma etching apparatus comprising:

a plasma generation chamber having a microwave introduction window and a gas supply entrance and having electromagnetic coils wound therearound, and

a reaction chamber communicating with said plasma generation chamber and having a susceptor on which is provided, in use, a substrate, the main surface of which susceptor faces the plasma flow which flows, when the apparatus is in use, from said plasma generation chamber, said gas supply entrance being provided in a side wall of said plasma generation chamber spaced apart from said microwave introduction window, said side wall being parallel to said plasma flow.

According to the present invention, the gas supply entrance is preferably provided in an internal guide covering said side wall.

According to the present invention, the side wall parallel to the plasma flow in the plasma generation chamber is constantly cleaned during the etching operation, and thus the reaction product cannot be firmly adhered to the side wall or the gas supply entrance.

For a better understanding of the invention and to show how the same may be carried into effect, reference will now be made by way of example only, to Figures 3 to 5 of the accompanying drawings in which:

Figures 1A to 1D are cross-sectional step views illustrating an ECR etching process;

Fig. 2 is a schematic view of a conventional ECR etching device;

Fig. 3 is a schematic view of an example of an ECR etching device according to the present invention; and,

Figs. 4 and 5 are schematic views of other examples of an ECR etching device according to the present invention.

The substrate 21 shown in Fig. 1D is disposed on a susceptor 9 of an ECR device shown in Fig. 3 and a 200 Khz, 60 W high frequency power generated by a high frequency power source is applied to the substrate 21. Thereafter, oxygen ($O_2$) gas is introduced into the gas generation chamber 1 from the gas supply entrance 4, at a gas supply rate of 9 cc/min. Further, $BCl_3$ gas is introduced into the reaction chamber 2 from the gas supply entrance 8 at a rate of 1 cc/mm. The inner pressure of the ECR device is maintained at $1.5 \times 10^{-3}$ Torr, and a 1 kW microwave is directed into the plasma generation chamber 1 through the microwave introduction window 6.

The microwave and the magnetic field generated by the electromagnet 7 produce an electron cyclotron resonance (ECR) effect, which causes $O_2$ gas to become a plasma. Then, using the $O_2$ gas plasma, the resist-formed substrate 21 is plasma etched so that an opening 29 is formed in the lower resist layer 24. During this plasma etching, the upper resist layer 26 is etched.

In the conventional technique in which both oxygen and $BCl_3$ are introduced into the plasma generation chamber 1 through the gas supply entrance 4, the etching selectivity ratio to the middle layer 25 is about 10 to about 20. In the present invention, however, in which oxygen and $BCl_3$ are individually introduced into the plasma generation chamber 1 through the gas supply entrances 4 and 8, respectively, the etching selectivity ratio to the middle resist layer 25 and the lower resist layer 24 is high, e.g., about 40. Namely, the middle layer 25 acts as a satisfactory mask when etching the lower resist layer 24, and thus an accurately shaped opening 29 is formed in the resist layer 24, without side etching. In the example, a reaction product did not adhere to the surface of the microwave introduction window 6.

As in other examples, when using $O_2$ as a plasma generation gas as mentioned above, $SiCl_4$, $SiF_4$, $SiBr_4$, $TiCl_4$, HBr, $Br_2$, $SO_2$, $S_2Cl_2$, $SCl_2$, CO, $Co_2$, HF, HCl or $Cl_2$ can be advantageously used in place of $BCl_3$.

As other examples, when using $CO_2$, or a mixed gas of $O_2$ and $CO_2$, $SiCl_4$, $SiF_4$, $SiBr_4$, $TiCl_4$, HBr, $Br_2$, $SO_2$, $S_2Cl_2$, CO, HF, HCl, $SCl_2$ or $Cl_2$ can be also advantageously used in place of $BCl_3$.

Other examples of the ECR etching device according to the present invention will be explained.

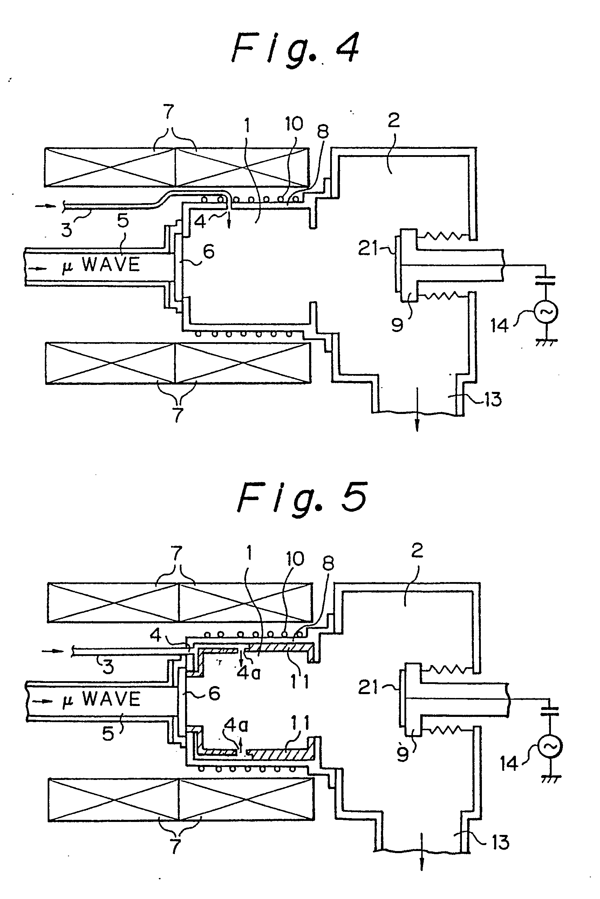

Figures 4 and 5 are schematic cross-sectional views of an example of the ECR etching device according to the present invention, respectively.

The examples of the ECR etching device shown in Figs. 4 and 5 are different from the conventional example shown in Fig. 2, in the position at which the gas supply entrance 4 is arranged. Namely, in the conventional case, the gas supply entrance 4 to the plasma generation chamber 1 is provided in the wall near the microwave introduction window 6, but in the examples of the present invention, the gas supply entrance 4a is provided away from the microwave introduction window 6. Namely, in Fig. 4, the gas supply entrance 4 is arranged in the side wall 8 of the plasma generation chamber 1, the side wall 8 being parallel to the plasma flow 15. Further, in Fig. 5, the gas supply entrance 4a is substantially arranged in the wall 8, by providing an additional inner guide cover 11.

The structure of other examples shown in Figs. 4 and 5 is substantially the same as the conventional example shown in Fig, 2. The cooling pipe 10 in Figs. 4 and 5 may, of course, be provided in Fig. 2.

According to the present invention, by using the ECR etching device shown in Figs. 4 and 5, the side wall which has the gas supply entrances 4 and 4a into the plasma generation chamber 1 is parallel to the plasma flow and is refreshed or cleaned during the etching. Thus it is not necessary to consider the separation of adhesion substance to thereby prevent the generation of contamination.

## Claims

1. An electron cyclotron resonance (ECR) plasma etching process using an ECR etching apparatus having a plasma generation chamber, a reaction chamber connected with said plasma generation chamber, and gas supply entrances provided in the respective chambers, comprising the steps of:
directing microwaves into said plasma generation chamber,
applying a magnetic field to said plasma generation chamber,
supplying a first gas which is used for generating plasma, to said plasma generation chamber, and
supplying a second gas which is used for generating a deposit of a protective film to said reaction chamber.

2. An ECR plasma etching process as claimed in claim 1, wherein said first gas which is used for generating plasma is constituted by one or more of argon (Ar), oxygen ($O_2$), nitrogen ($N_2$), helium (He), xenon (Xe), krypton (Kr), chlorine ($C_{12}$), fluorine ($F_2$), nitrogen trifluoride ($NF_3$), sulphur hexafluoride ($SF_6$), bromine ($Br_2$), hydrogen bromide (HBr), nitrogen dioxide ($NO_2$), carbon dioxide ($CO_2$), carbon monoxide (CO) and nitrogen monoxide (NO).

3. An ECR plasma etching process as claimed in claim 1 or 2, wherein the material to be etched is aluminium, an aluminium alloy, a resist, a polymer compound, a silicon, an alloy or compound of silicon and a refractory metal, a high refractory metal, a stacked body formed of an alloy or compound of silicon and a refractory metal, or a refractory metal.

4. An ECR plasma etching process as claimed in claim 1, wherein the material to be etched is a resist or a high polymer compound, said first gas which is used for generating said plasma is oxygen, carbon dioxide or a mixed gas of oxygen and carbon dioxide, and said second gas which is used for generating said deposit is constituted by one or more of carbon dioxide ($CO_2$), chlorine ($Cl_2$), boron trichloride ($BCl_3$), silicon tetrachloride ($SiCl_4$), silicon tetrafluoride ($SiF_4$), silicon tetrabromide ($SiBr_4$), titanium tetrachloride ($TiCl_4$), hydrogen bromide (HBr), bromine ($Br_2$), sulphur dioxide ($SO_2$), disulphur dichloride ($S_2Cl_2$), sulphur dichloride ($SCl_2$), carbon monoxide (CO), hydrogen fluoride (HF), and hydrogen chloride (HCl).

5. An ECR etching process as claimed in any one of claims 1 to 4, wherein water is added to said second gas which is used for generating said deposit.

6. An electron cyclotron resonance (ECR) plasma etching apparatus comprising:
a plasma generation chamber having a microwave introduction window and a first supply entrance for a first gas which is a plasma generating gas, and having electromagnetic coils wound therearound, and
a reaction chamber communicating with said plasma generation chamber having a second supply entrance for a second gas which is a gas for generating a deposit to form a side etching prevention film and having a susceptor on which is to be provided a substrate, the main surface of which is positioned to face a plasma flow which flows, when the apparatus is in use, from said plasma generation chamber.

7. An ECR plasma etching apparatus as claimed in claim 6, wherein including a source of a first gas which is used for generating plasma and which is constituted by one or more of argon (Ar), oxygen ($O_2$), carbon dioxide ($CO_2$), carbon monoxide (CO), nitrogen ($N_2$), helium (He), xenon (Xe), krypton (Kr), chlorine ($Cl_2$), fluorine ($F_2$) nitrogen trifluoride ($NF_3$), sulphur hexafluoride ($SF_6$), bromine ($Br_2$), hydrogen bromide (HBr), nitrogen dioxide ($NO_2$), nitrogen monoxide (NO), hydrogen fluoride (HF), and hydrogen chloride (HCl).

8. An ECR plasma etching apparatus as claimed in claim 6, which, when the material to be etched is a resist or a high polymer compound, includes a source of a first gas for generating said plasma and which is oxygen, carbon dioxide or a mixed gas of oxygen and carbon dioxide and which includes a source of a second gas which is a gas for generating said deposit and which is constituted by one or more of carbon dioxide ($CO_2$), carbon monoxide (CO), chlorine ($Cl_2$), boron trichloride ($BCl_3$), silicon tetrachloride ($SiCl_4$), silicon tetrafluoride ($SiF_4$), silicon tetrabromide ($SiBr_4$), titanium tetrachloride ($TiCl_4$), hydrogen bromide (HBr), bromine ($Br_2$), sulphur dioxide ($SO_2$), disulphur dichloride ($S_2Cl_2$), sulphur dichloride ($SCl_2$), hydrogen fluoride (HF), and hydrogen chloride (HCl).

9. An ECR plasma etching apparatus as claimed in any one of claims 6 to 8, and including a source of water to be added to the second gas which is used for generating said deposit.

10. An electron cyclotron resonance (ECR) plasma etching apparatus comprising:
a plasma generation chamber having a microwave introduction window and a gas supply entrance and having electromagnetic coils wound therearound, and
a reaction chamber communicating with said plasma generation chamber and having a susceptor on which is provided, in use, a substrate, the main surface of which susceptor faces the plasma flow which flows, when the apparatus is in use, from said plasma generation chamber, said gas supply entrance being provided in a side wall of said plasma generation chamber spaced apart from said microwave introduction window, said side wall being parallel to said plasma flow.

11. An electron cyclotron resonance (ECR) plasma etching apparatus as claimed in claim 10, wherein said gas supply entrance is provided in an internal guide covering said side wall.

Fig. 1A

26
25
24
23
22
21

Fig. 1B

27

26
25
24
23
22
21

Fig. 1C

28

26
25
26
25
24
23
22
21

Fig. 1D

29

25
25
24
24
23
22
21

# Fig. 2

# Fig. 3

# F i g. 4

μ WAVE

# F i g. 5

μ WAVE